# FASCICULE DE BREVET EUROPEEN

(11) **EP 3 020 684 B1**
(45) Date de publication et mention de la délivrance du brevet: **18.10.2017**
(21) Numéro de dépôt: 15194295.0
(22) Date de dépôt: 12.11.2015
(51) Int. Cl.: B81C 1/00

(54) **STRUCTURE D'ENCAPSULATION COMPORTANT UNE CAVITE COUPLEE A CANAL D'INJECTION DE GAZ FORME PAR UN MATERIAU PERMEABLE**
EINKAPSELUNGSSTRUKTUR MIT HOHLRAUM DER AN EINEN AUS EINEM DURCHLÄSSIGEN MATERIAL GEBILDETEN GASINJEKTIONSKANAL GEKOPPELT IST
ENCAPSULATION STRUCTURE COMPRISING A COUPLED CAVITY HAVING A GAS-INJECTION CHANNEL FORMED BY A PERMEABLE MATERIAL

(30) Priorité: 13.11.2014 FR 1460950
(43) Date de publication de la demande: 18.05.2016
(73) Titulaire: Commissariat à l'Énergie Atomique et aux Énergies Alternatives, 75015 Paris (FR)
(72) Inventeur: NICOLAS, Stéphane, 38240 Meylan (FR)
(74) Mandataire: Brevalex

(56) Documents cités:
- EP-A1- 2 778 121
- EP-A2- 2 692 689

## Description

### DOMAINE TECHNIQUE ET ART ANTÉRIEUR

L'invention concerne le domaine de l'encapsulation, ou packaging, notamment pour des micro-dispositifs de type MEMS (systèmes micro-électro-mécaniques), NEMS (systèmes nano-électro-mécaniques), MOEMS (systèmes micro-opto-électro-mécaniques), NOEMS (systèmes nano-opto-électro-mécaniques), ou encore des capteurs de pressions, dans des cavités hermétiques et sous des atmosphères particulières.

L'encapsulation d'un micro-dispositif dans une cavité permet d'une part de le protéger vis-à-vis des éléments extérieurs (humidité, pollution particulaire, éléments réactifs tels que l'oxygène ou autres gaz non neutres), et d'autre part de contrôler l'atmosphère dans laquelle le micro-dispositif est encapsulé, à la fois en termes de pression et de composition gazeuse.

Les pressions avec lesquelles les micro-dispositifs sont encapsulés sont très variables suivant leur application et sont typiquement comprises entre environ 1 bar à 10⁻³ mbar. Une contrainte récurrente lors d'une telle encapsulation est donc de réaliser un contrôle très précis de la pression avec laquelle le micro-dispositif est encapsulé. Par exemple, dans le cas d'un micro-dispositif MEMS de type gyromètre, un vide correspondant à une pression comprise entre environ 10⁻¹ et 10⁻³ mbar est généralement nécessaire pour son bon fonctionnement. Dans le cas d'un micro-dispositif MEMS de type accéléromètre, une pression d'encapsulation comprise entre quelques mbar et la pression atmosphérique est recherchée, en fonction de l'amortissement désiré.

Une encapsulation simultanée de plusieurs micro-dispositifs est généralement réalisée à l'échelle du substrat, c'est-à-dire par un procédé collectif d'encapsulation, afin de réduire leur coût de fabrication. Pour cela, il est possible de réaliser ces micro-dispositifs collectivement sur des tranches (wafers ou substrats) de silicium puis de les encapsuler dans des cavités via un report d'un capot correspondant généralement à un autre substrat en silicium ou en verre dans lequel les cavités sont gravées. Il existe différentes techniques de scellement permettant d'obtenir un assemblage hermétique des deux substrats, comme par exemple le scellement moléculaire, le scellement métallique, le scellement anodique, ou encore le scellement par verre fritté.

L'encapsulation peut également être réalisée par une ou plusieurs couches minces déposées sur des portions sacrificielles recouvrant les micro-dispositifs et qui, après élimination, forment des volumes libres entre le substrat et les couches minces correspondant aux cavités (encapsulation « Thin Film Packaging », également appelée TFP, ou PCM pour « Packaging Couche Mince »).

Les principaux paramètres à prendre en compte pour le contrôle de la pression dans une cavité sont :
- l'herméticité du joint de scellement éventuellement présent entre les substrats ;
- la perméation des gaz à travers les parois de la cavité formées par les substrats et/ou le joint de scellement ;
- les dégazages des différents matériaux présents dans la cavité.

Il existe des composants particuliers, appelés centrales inertielles, comprenant chacun un accéléromètre tri-axes, un gyromètre tri-axes ainsi qu'un magnétomètre tri-axes, formant ainsi un capteur inertiel à 9 axes de détection. Pour ce type de composant, les dispositifs microélectroniques triaxiaux (accéléromètre, gyromètre et magnétomètre) sont généralement fabriqués indépendamment les uns des autres puis assemblés lors du packaging final du composant, ce qui correspond dans ce cas à un procédé d'encapsulation non collectif. Pour des raisons de réduction des coûts de fabrication de ce type de composant, il est envisagé d'intégrer les différents dispositifs microélectroniques du composant sur un même substrat. Toutefois, ce type d'intégration pose des problèmes.

En effet, un accéléromètre fonctionne généralement avec une pression résiduelle (pression régnant dans la cavité d'encapsulation) assez élevée (supérieure à environ 1 mbar) afin d'être suffisamment amorti, alors qu'un gyromètre a généralement besoin d'une pression résiduelle la plus faible possible (par exemple entre environ 10⁻¹ mbar et 10⁻⁴ mbar) pour fonctionner de manière optimale. Or, il est très difficile de packager et sceller hermétiquement des cavités avec des pressions résiduelles très différentes sur un même substrat.

Une première solution consiste à réaliser un scellement des cavités de l'accéléromètre et du gyromètre sous une pression très faible (par exemple entre environ 10⁻³ et 10⁻⁵ mbar), disposer un matériau getter dans la cavité du gyromètre et ne pas en mettre dans la cavité de l'accéléromètre. Cette première solution fonctionne mais ne permet pas d'atteindre des différences de pression importantes entre les deux cavités: typiquement, la pression résiduelle dans la cavité de l'accéléromètre est comprise entre quelques mbar et quelques dizaines de mbar en raison des dégazages des différents matériaux contenus dans la cavité de l'accéléromètre lors du scellement. Or, pour certains accéléromètres, il est nécessaire d'avoir une pression résiduelle supérieure à environ 100 mbar voir proche d'environ 1 bar (fort amortissement). Dans ce cas, cette première solution ne fonctionne pas.

Une deuxième solution consiste à réaliser le scellement des deux cavités sous pression atmosphérique (par exemple à une pression d'environ 1 bar), et disposer un matériau getter dans la cavité du gyromètre. Toutefois, en raison de la capacité de pompage limitée et de l'encombrement limité du matériau getter (dont la taille maximale est limitée par les dimensions de la cavité), il n'est généralement pas possible de descendre à une pression résiduelle inférieure à environ 1 mbar dans la cavité du gyromètre car le getter est saturé avant d'atteindre une telle pression.

Quelle que soit la solution choisie (scellement à faible pression ou à pression atmosphérique), un des deux dispositifs n'est pas encapsulé avec une pression résiduelle correspondant à celle nécessaire à son bon fonctionnement.

Le document US 8 350 346 B1 décrit un composant comportant des cavités de volumes différents dans lesquelles sont encapsulés un gyromètre et un accéléromètre. Le volume de la cavité dans laquelle est encapsulé l'accéléromètre est inférieur à celui de la cavité dans laquelle le gyromètre est encapsulé. Ainsi, la pression obtenue dans la cavité de l'accéléromètre est plus élevée que celle obtenue dans la cavité du gyromètre. Toutefois, une telle structure ne permet pas d'obtenir des différences de pressions allant de 1 bar à 10⁻³ mbar entre les différentes cavités.

Le document US 7 659 150 B1 décrit une structure d'encapsulation comportant plusieurs cavités dans lesquelles plusieurs micro-dispositifs sont encapsulés. Différentes pressions sont obtenues dans ces cavités grâce à des ouvertures de tailles différentes formées à travers le capot et débouchant directement dans les cavités. Dans ce document, la fermeture des cavités se fait par un dépôt sous vide sans injection de gaz, après réglage de la pression. La pression atteignable avec ce type de structure est donc limitée à environ 1 mbar.

Le document US 2007/0259470 A1 décrit une structure d'encapsulation dans laquelle une partie du joint de scellement est formé d'un matériau perméable dont la perméabilité peut être modifiée en fonction de la température à laquelle est soumise la structure. Une telle structure n'est toutefois pas adaptée pour réaliser, sur un même substrat, plusieurs cavités dans lesquelles des micro-dispositifs sont encapsulés sous des atmosphères différentes.

Le document US 2012/0326248 A1 décrit une structure d'encapsulation dans laquelle plusieurs micro-dispositifs sont encapsulés dans des cavités différentes. Une ouverture formée à travers le capot débouche sur un matériau perméable pour injecter du gaz dans une cavité. Cette structure d'encapsulation a notamment pour inconvénient que les différences de pression entre les différentes cavités sont très limitées en raison du matériau perméable faisant communiquer entre elles les différentes cavités. De plus, en raison de ce matériau perméable présent entre les cavités, le gaz a tendance, au cours du temps, à passer d'une cavité à l'autre, et les valeurs des pressions au sein des différentes cavités ont donc tendance à changer au cours du temps.

### EXPOSÉ DE L'INVENTION

Un but de la présente invention est de proposer une structure d'encapsulation comportant au moins une cavité dont l'atmosphère peut être aisément contrôlée, qui soit compatible avec une encapsulation de plusieurs micro-dispositifs dans différentes cavités à des pressions différentes qui soient stables dans le temps, et permettant d'avoir, entre les atmosphères des cavités, des différences de pression plus importantes qu'avec les structures de l'art antérieur.

Pour cela, il est proposé une structure d'encapsulation comportant au moins :
- un capot solidarisé à au moins un premier substrat et formant au moins une cavité entre le capot et le premier substrat ;
- une couche d'au moins un premier matériau perméable à un gaz, disposée dans le capot et/ou dans le premier substrat et/ou à l'interface entre le capot et le premier substrat, et formant au moins une partie d'une paroi de la cavité ;
- une portion d'au moins un deuxième matériau non perméable audit gaz, dont l'épaisseur est supérieure ou égale à celle de la couche du premier matériau, et entourant, dans le plan de la couche du premier matériau, au moins une première partie de la couche du premier matériau formant ladite partie de la paroi de la cavité ;
- une ouverture traversant le capot ou le premier substrat et débouchant sur ou dans ladite partie de la couche du premier matériau.

Une telle structure d'encapsulation permet de régler la pression avec laquelle la cavité peut être fermée en jouant sur plusieurs paramètres :
- les dimensions de l'ouverture ;
- les dimensions de la cavité ;
- les dimensions de la partie de la couche du premier matériau,
- les paramètres de mise en oeuvre d'une injection de gaz dans la cavité à travers l'ouverture et la partie de la couche du premier matériau.

En fonction de ces différents paramètres, il est donc possible d'obtenir des pressions très différentes dans la cavité. Ainsi, une telle structure d'encapsulation est parfaitement compatible avec la réalisation de plusieurs cavités fermées avec des atmosphères très différentes les unes des autres, par exemple avec des différences de pression allant de plusieurs bars à environ 10⁻⁴ mbar.

De plus, la portion du deuxième matériau non perméable permet d'assurer une bonne étanchéité de la cavité, notamment lorsque plusieurs cavités sont réalisées de manière adjacentes les unes des autres et que la couche du premier matériau est commune à ces différentes cavités.

Cette structure d'encapsulation a également pour avantage de pouvoir être réalisée via des technologies de fabrication MEMS standards, ainsi que via des technologies de scellement standards.

Dans cette structure d'encapsulation, la couche du premier matériau, la portion du deuxième matériau et l'ouverture sont agencés tels qu'une injection de gaz dans la cavité soit possible à travers l'ouverture et la première partie de la couche du premier matériau.

Une telle structure d'encapsulation peut être avantageusement utilisée pour réaliser une encapsulation collective de plusieurs micro-dispositifs de types différents et destinés à fonctionner sous des atmosphères différentes, c'est-à-dire à des pressions différentes et/ou dans des environnements gazeux différents.

Le terme « *gaz »* peut désigner ici un gaz ou un mélange de plusieurs gaz formés des éléments chimiques du groupe 18 du tableau périodique des éléments, c'est-à-dire de l'hélium et/ou du néon et/ou de l'argon et/ou du krypton et/ou du xénon et/ou du radon, également appelés gaz rares, ou gaz inertes, ou gaz nobles. Avantageusement, le gaz comporte de l'hélium et/ou de l'argon.

Le gaz injecté dans la cavité par l'intermédiaire du premier matériau perméable est un gaz avantageusement inerte vis-à-vis des matériaux de la structure avec lesquels il peut entrer en contact. Ce gaz peut notamment être un gaz permettant de régler la pression dans la cavité et qui est non-réactif vis-à-vis d'autres matériaux de la structure.

Ladite partie de la couche du premier matériau peut entourer la cavité. Dans ce cas, la portion du deuxième matériau peut former un cordon entourant la cavité.

La structure d'encapsulation peut comporter en outre au moins un micro-dispositif disposé dans la cavité. Le micro-dispositif peut être de type MEMS et/ou NEMS et/ou MOEMS et/ou NOEMS. Notamment, le micro-dispositif peut être de type inertiel, et correspondre par exemple à un accéléromètre ou un gyromètre ou un magnétomètre ou encore un capteur de pression.

Le deuxième matériau peut être un métal (par exemple du titane et/ou de l'aluminium et/ou du cuivre) et/ou le premier matériau peut comporter de l'oxyde de semi-conducteur (par exemple du SiO₂) et/ou du nitrure de semi-conducteur (par exemple du SiN ou du Si₃N₄) et/ou du verre (par exemple du verre de type borosilicate, par exemple de type « pyrex », verre de silice ou verre de type *« borofloat »*)*.*

Au moins une partie de la portion du deuxième matériau peut être entourée par une deuxième partie de la couche du premier matériau.

La portion du deuxième matériau peut être disposée au moins en partie dans la couche du premier matériau.

Le capot peut comporter au moins un deuxième substrat. Dans ce cas, la structure d'encapsulation correspond à une structure de type « report de capot ».

Dans un premier mode de réalisation, la couche du premier matériau et la portion du deuxième matériau peuvent être disposées à l'interface entre le premier substrat et le deuxième substrat. Avantageusement, l'épaisseur de la portion du deuxième matériau peut être supérieure à celle de la couche de premier matériau.

Dans un deuxième mode de réalisation, la couche du premier matériau peut être disposée entre une couche support du premier substrat et une couche supérieure du premier substrat.

Dans ce cas, la couche supérieure du premier substrat peut être une couche de semi-conducteur dans laquelle le micro-dispositif est réalisé.

De plus, le deuxième matériau peut correspondre à un semi-conducteur similaire à celui de la couche supérieure du premier substrat, et/ou le premier substrat peut être de type SOI et la couche du premier matériau peut correspondre à la couche isolante du premier substrat.

La structure d'encapsulation peut comporter en outre au moins un matériau de bouchage disposé sur et/ou dans l'ouverture tel que la cavité soit fermée hermétiquement. L'herméticité de la cavité est dans ce cas assurée conjointement par les matériaux du capot et du premier substrat, la portion du deuxième matériau et le matériau de bouchage.

Dans ce cas, l'ouverture peut traverser ladite partie de la couche du premier matériau et déboucher sur une portion de matériau électriquement conducteur, et le matériau de bouchage peut correspondre à une couche électriquement conductrice disposée au moins dans l'ouverture et reliant électriquement la portion de matériau électriquement conducteur à un contact électrique disposé hors de l'ouverture. Ainsi, l'ouverture utilisée pour régler la pression d'encapsulation de la cavité sert également pour former un via traversant (TSV) reliant électriquement le contact électrique extérieur avec la portion de matériau électriquement conducteur qui correspond par exemple à une électrode du micro-dispositif.

Un matériau getter peut être disposé dans la cavité. Un tel matériau getter a pour fonction d'assurer la qualité de l'atmosphère en piégeant les gaz résiduels tels que par exemple de l'oxygène, de l'azote, de l'hydrogène, de l'eau, du monoxyde de carbone et le dioxyde de carbone, et ainsi obtenir un vide dans la cavité (pression par exemple inférieure à environ 1 mbar).

La structure d'encapsulation peut comporter plusieurs cavités formées entre le capot et le premier substrat et disposées de manière adjacentes les unes par rapport aux autres, dans laquelle au moins une dimension de chacune des parties de la couche du premier matériau formant les parties de la paroi d'au moins deux des cavités est différente pour chacune desdites au moins deux des cavités et/ou dans laquelle une dimension d'une section de l'ouverture associée à chacune d'au moins deux des cavités est différente. Différents micro-dispositifs peuvent ainsi être encapsulés dans les différentes cavités et sous des atmosphères différentes. Il est par exemple possible qu'un dispositif de type centrale inertielle comportant un micro-dispositif de type gyromètre, un de type accéléromètre et un de type magnétomètre soient encapsulés dans trois cavités différentes de la structure d'encapsulation avec des pressions différentes les unes des autres et adaptées au fonctionnement de chacun de ces micro-dispositifs.

Les portions du deuxième matériau entourant chacune des parties de la couche du premier matériau formant la partie de la paroi de chacune des cavités peuvent être distinctes les unes des autres.

L'invention concerne également un procédé de réalisation d'une structure d'encapsulation, comportant au moins les étapes suivantes :
- réalisation d'au moins un capot et d'au moins un premier substrat destinés à être solidarisés l'un à l'autre en formant au moins une cavité entre le capot et le premier substrat ;
- réalisation d'une couche d'au moins un premier matériau perméable à un gaz, disposée dans le capot et/ou dans le premier substrat et/ou à une interface entre le capot et le premier substrat, et destinée à former au moins une partie d'une paroi de la cavité ;
- réalisation d'au moins une portion d'au moins un deuxième matériau non perméable audit gaz, dont l'épaisseur est supérieure ou égale à celle de la couche du premier matériau, et entourant, dans le plan de la couche du premier matériau, au moins une première partie de la couche du premier matériau destinée à former ladite partie de la paroi de la cavité ;
- solidarisation du capot au premier substrat, formant la cavité ;
- réalisation d'au moins une ouverture traversant le capot ou le premier substrat et débouchant sur ou dans ladite partie de la couche du premier matériau.

Le procédé de réalisation peut comporter en outre, après l'étape de réalisation de l'ouverture, une étape d'injection dudit gaz dans la cavité à travers l'ouverture et ladite partie de la couche du premier matériau, puis une étape de fermeture hermétique de la cavité par la formation d'au moins un matériau de bouchage sur et/ou dans l'ouverture.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 3 représentent une structure d'encapsulation, objet de la présente invention, selon un premier mode de réalisation ;
- la figure 4 représente une partie d'une structure d'encapsulation, objet de la présente invention, selon une variante du premier mode de réalisation ;
- les figures 5A à 5I représentent les étapes d'un procédé de réalisation de la structure d'encapsulation, objet de la présente invention, selon le premier mode de réalisation ;
- les figures 6A à 6K représentent les étapes d'un procédé de réalisation d'une structure d'encapsulation, objet de la présente invention, selon un deuxième mode de réalisation ;
- les figures 7A à 7E représentent une partie des étapes du procédé de réalisation de la structure d'encapsulation, objet de la présente invention, selon le deuxième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

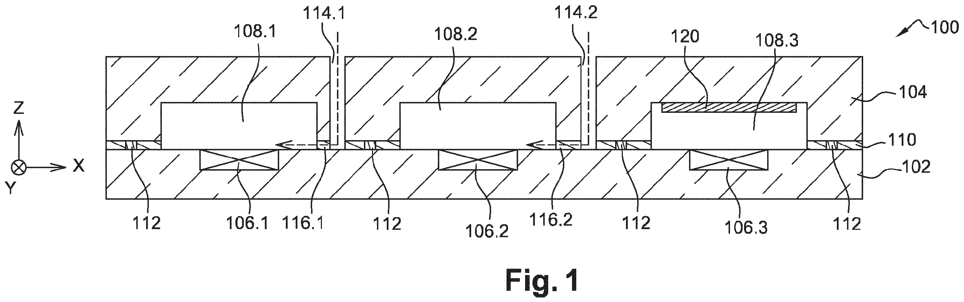

On se réfère tout d'abord à la figure 1 qui représente une vue en coupe de profil d'une structure d'encapsulation 100 selon un premier mode de réalisation.

La structure d'encapsulation 100 est ici formée par l'assemblage d'un premier substrat 102 avec un deuxième substrat 104. Ces deux substrats 102 et 104 comportent chacun un matériau non perméable vis-à-vis d'un gaz, avantageusement un gaz noble (correspondant à un type de gaz noble ou un mélange de différents types de gaz nobles) destiné à être injecté dans des cavités de la structure 100, par exemple du semi-conducteur tel que du silicium.

Un ou plusieurs micro-dispositifs 106 sont réalisés dans et/ou sur le premier substrat 102 qui sert de support à ces micro-dispositifs 106. Sur l'exemple de la figure 1, trois micro-dispositifs 106.1, 106.2 et 106.3 sont réalisés au niveau d'une face avant du premier substrat 102. Les micro-dispositifs 106 sont chacun encapsulés dans une cavité 108 (référencées 108.1, 108.2 et 108.3 sur la figure 1 respectivement pour chacun des micro-dispositifs 106.1, 106.2 et 106.3) formée entre les deux substrats 102, 104. Dans ce premier mode de réalisation, les cavités 108 sont formées dans une partie de l'épaisseur du deuxième substrat 104 qui forme le capot de la structure 100.

Les substrats 102 et 104 sont solidarisés l'un à l'autre. Une couche 110 est disposée à l'interface entre les substrats 102 et 104, en périphérie des cavités 108. Cette couche 110 est formée d'au moins un premier matériau qui est perméable vis-à-vis du gaz, tel que de l'hélium et/ou de l'argon, destiné à être injecté dans les cavités 108. Le premier matériau comporte par exemple du SiO₂ et/ou un ou plusieurs composants dérivés du SiO₂ tels que du SiON ou du SiOC, déposés en couche mince, par exemple avec une épaisseur comprise entre environ 10 nm et 10 µm. La couche 110 peut également comporter du nitrure de silicium et/ou du verre.

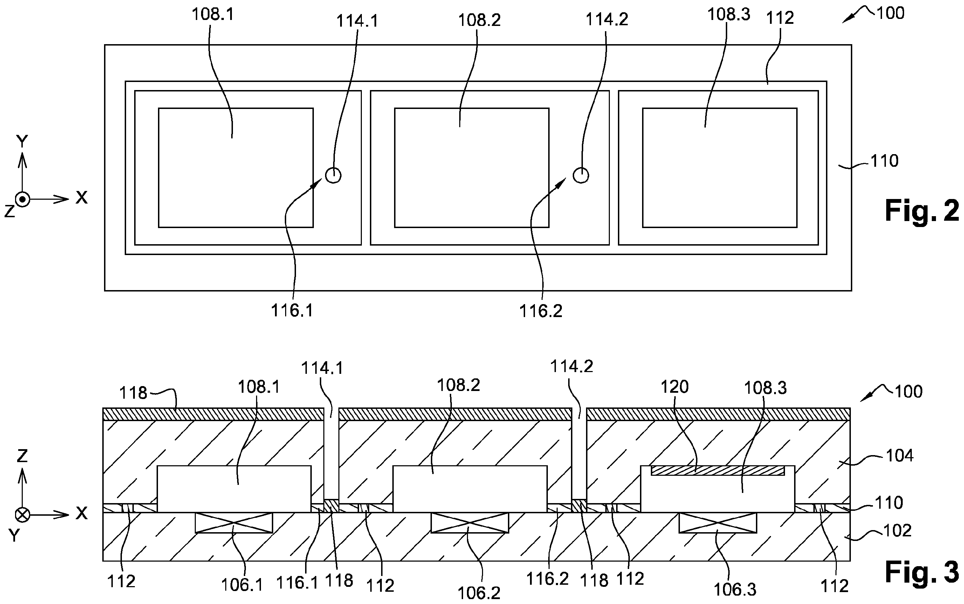

Une portion 112 d'au moins un deuxième matériau non perméable vis-à-vis du gaz destiné à être injecté dans les cavités 108 est formée dans la couche 110. Ici, les faces supérieures de la portion 112 et de la couche 110 forment une surface continue, et les faces inférieures de la portion 112 et de la couche 110 forment également une surface continue. Cette portion 112 est réalisée ici sous la forme d'un cordon entourant chacune des cavités 108. La portion 112 est par exemple formée d'une ou plusieurs couches métalliques superposées, par exemple de titane et/ou d'aluminium et/ou de cuivre et/ou d'or et/ou de germanium. L'épaisseur de la portion 112 est supérieure ou égale (égale sur l'exemple de la figure 1) à celle de la couche 110, et par exemple comprise entre environ 0,2 µm et 10 µm. Ainsi, du fait que les matériaux des substrats 102 et 104 et de la portion 112 sont non perméables vis-à-vis du gaz destiné à être injecté dans les cavités 108, les atmosphères des cavités 108 sont bien isolées les unes des autres par ces matériaux. Sans la présence de la portion 112, les atmosphères des cavités 108 communiqueraient les unes avec les autres à travers le matériau de la couche 110 qui est perméable vis-à-vis du gaz injecté. La figure 2 représente une vue en coupe de dessus de la couche 110 et de la portion 112.

Afin que du gaz puisse être injecté dans les cavités 108, des ouvertures 114 sont formées à travers le deuxième substrat 104, au niveau des parois latérales des cavités 108. Les ouvertures 114 ont par exemple ici, dans le plan parallèle à la face avant du premier substrat 102, des sections de forme circulaire. Les ouvertures 114 sont de préférence prolongées à travers la couche 110. Chacune des ouvertures 114 est réalisée telle qu'elle débouche sur ou dans une partie de la couche 110 qui est délimitée par la portion 112 et qui communique avec l'une des cavités 108. Sur l'exemple des figures 1 et 2, une première ouverture 114.1 est réalisée telle qu'elle débouche dans une partie 116.1 de la couche 110 qui est délimitée par la portion 112 et qui communique avec la première cavité 108.1. Ainsi, le gaz injecté dans la première ouverture 114.1 traverse cette partie 116.1 de la couche 110 qui sépare la première ouverture 114.1 de la première cavité 108.1. Une deuxième ouverture 114.2 est réalisée telle qu'elle débouche dans une partie 116.2 de la couche 110 qui est délimitée par la portion 112 et qui communique avec la deuxième cavité 108.2. Ainsi, le gaz injecté dans la deuxième ouverture 114.2 traverse cette partie 116.2 de la couche 110 qui sépare la deuxième ouverture 114.2 de la deuxième cavité 108.2. Enfin, pour la troisième cavité 108.3, aucune ouverture n'est ici formée pour déboucher sur ou dans une partie de la couche 110 communiquant avec la troisième cavité 108.3.

Sur l'exemple de la figure 1, la portion 112 est entourée par une deuxième partie de la couche 110 correspondant à la partie extérieure de la couche 110.

La quantité de gaz injectée dans chaque cavité 108 dépend de plusieurs paramètres :
- les dimensions (par exemple le diamètre dans le cas d'une ouverture de section circulaire) de la section de l'ouverture 114 associée à la cavité ;
- les dimensions de la partie 116 de la couche 110 de matériau perméable se trouvant entre l'ouverture 114 et la cavité 108, c'est-à-dire la longueur (dimension selon l'axe X sur les figures 1 et 2) et la section (largeur x épaisseur) de la portion de matériau perméable que doit traverser le gaz avant d'aboutir dans la cavité 108 ;
- les paramètres d'injection du gaz, c'est-à-dire la pression avec laquelle le gaz est injecté ainsi que la durée de cette injection de gaz.

Sur l'exemple des figures 1 et 2, les ouvertures 114.1 et 114.2 ont des diamètres sensiblement similaires. De plus, l'injection de gaz est réalisée simultanément dans les cavités 108.1 et 108.2 au cours d'une même étape en disposant la structure d'encapsulation 100 dans une enceinte dans laquelle un gaz est présent à une certaine pression, par exemple comprise entre environ 0,5 bar et 10 bars, et pendant une durée définie en fonction de la pression dans l'enceinte et de la pression souhaitée dans les cavités, par exemple comprise entre environ quelques minutes et quelques heures. En outre, du fait que l'épaisseur de la couche 110 est sensiblement constante au niveau de l'ensemble de la structure d'encapsulation 100, les sections des parties 116.1 et 116.2 de la couche 110 traversées par le gaz pour aboutir dans les cavités 108.1 et 108.2 sont les mêmes. Par contre, les ouvertures 114.1 et 114.2 sont réalisées à des distances différentes des cavités 108.1 à 108.2. Ainsi, la longueur de la partie 116.1 de la couche 110 traversée par le gaz pour aboutir dans la première cavité 108.1 est inférieure à celle traversée par ce gaz pour aboutir dans la deuxième cavité 108.2, ce qui se traduit, après la mise en oeuvre de l'étape d'injection de gaz, par une pression résiduel de ce gaz dans la première cavité 108.1 supérieure à celle dans la deuxième cavité 108.2.

Après cette étape d'injection de gaz dans les cavités 108.1 et 108.2, ces cavités sont refermées hermétiquement en bouchant les ouvertures 114.1 et 114.2 via le dépôt d'un matériau de bouchage, ici sous la forme d'une couche 118, au moins dans les ouvertures 114.1 et 114.2, l'épaisseur de la couche 118 étant ici avantageusement supérieure ou égale à l'épaisseur de la couche 110 afin que les parties 116.1 et 116.2 de la couche 110 par lesquelles le gaz a été injecté dans les cavités 108.1 et 108.2 ne soient plus en contact avec l'atmosphère extérieure aux cavités 108.1 et 108.2. Dans le cas d'un matériau de bouchage 118 déposé de façon conforme dans les ouvertures 114, l'épaisseur de ce matériau de bouchage 118 peut être faible et notamment inférieure à l'épaisseur de la couche 110 car un tel dépôt conforme permet de recouvrir les parois des ouvertures 114 pour rendre hermétique les cavités 108 sans nécessairement remplir les ouvertures 114. Lorsque les ouvertures 114 sont réalisées à travers une partie de l'épaisseur de la couche 110, la couche de bouchage 118 est alors réalisée avec une épaisseur supérieure ou égale à celle de cette partie de l'épaisseur de la couche 110. Enfin, si les ouvertures 114 sont réalisées telles qu'elles débouchent sur la couche 110 sans la traverser, alors l'épaisseur de la couche de bouchage 118 est choisie au moins égale à l'épaisseur minimum assurant une fermeture hermétique des ouvertures 114, cette épaisseur minimum étant fonction notamment du ou des matériaux utilisés pour réaliser la couche 118. Sur l'exemple de la figure 3, la couche 118 est déposée dans les ouvertures 114 mais également sur le deuxième substrat 104.

Grâce à l'imperméabilité obtenue entre les différentes cavités 108 de la structure 100, il est par exemple possible d'obtenir dans une des cavités 108 une pression finale proche de 1 bar, voir plus de 1 bar, et dans une cavité adjacente une pression très faible, par exemple inférieure à environ 10⁻¹ mbar, et cela grâce notamment à la portion 112 non perméable au gaz et formée dans la couche 110.

Sur l'exemple des figures 1 et 2, les cavités 108 ont des dimensions sensiblement similaires les unes par rapport aux autres. En variante, il est possible que les cavités 108 aient des dimensions différentes les unes par rapport aux autres.

Dans la structure 100 précédemment décrite, une portion de matériau getter 120 est disposée dans la troisième cavité 108.3. Cette portion de matériau getter 120 est destinée à réaliser une absorption de gaz afin de réduire la pression au sein de la troisième cavité 108.3. Ainsi, dans la structure d'encapsulation 100 précédemment décrite, la pression régnant dans la première cavité 108.1 est supérieure à celle régnant dans la deuxième cavité 108.2 qui est elle-même supérieure à celle régnant dans la troisième cavité 108.3. Dans cet exemple, du fait qu'aucun gaz n'est injecté dans la troisième cavité 108.3 et grâce à la présence du matériau getter 120, il est possible d'obtenir dans la troisième cavité 108.3 une pression résiduelle très faible par exemple inférieure ou égale à environ 1 mbar, voir un niveau de vide pouvant aller jusqu'à environ 10⁻³ mbar voir 10⁻⁴ mbar. La pression régnant dans la première cavité 108.1 est par exemple supérieure ou égale à environ 1 bar. La pression régnant dans la deuxième cavité 108.2 est par exemple comprise entre environ 10 mbar et plusieurs centaines de mbar (< 1 bar).

En variante, il est possible que des portions de matériau getter soient également disposées dans l'une ou plusieurs des autres cavités 108 de la structure 100.

L'assemblage du deuxième substrat 104 au premier substrat 102 peut correspondre par exemple à un scellement moléculaire, anodique, métallique ou verre fritté. La nature de la couche 110 est notamment fonction du type de scellement réalisé. Le scellement réalisé est toutefois compatible avec la présence d'une couche de matériau perméable vis-à-vis du gaz à injecter dans les cavités 108. Cet assemblage peut être réalisé ou non sous une atmosphère particulière afin qu'une composition gazeuse et/ou une pression particulières soient présentes dans les cavités 108 avant l'étape d'injection de gaz. Le choix d'une atmosphère particulière lors de l'assemblage des deux substrats 102, 104 peut notamment être réalisé en fonction de l'atmosphère souhaitée dans la ou les cavités 108 qui ne sont pas destinées à être soumises à une injection de gaz (comme la cavité 108.3 dans l'exemple décrit ici).

En variante de l'exemple décrit en liaison avec les figures 1 et 2, il est possible que les ouvertures 114.1 et 114.2 soient réalisées à des distances sensiblement similaires des cavités 108.1 à 108.2 afin que la longueur de la partie 116.1 de la couche 110 traversée par le gaz pour aboutir dans la première cavité 108.1 soit sensiblement similaire à celle traversée par ce gaz pour aboutir dans la deuxième cavité 108.2. Dans ce cas, une différence de pression dans les cavités 108.1 et 108.2 peut être obtenue en réalisant les ouvertures 114.1 et 114.2 avec des dimensions différentes l'une par rapport à l'autre (avec des diamètres différents dans le cas d'ouvertures 114 de section circulaire, ou avec des côtés de dimensions différentes dans le cas d'ouvertures 114 de section de forme autre que circulaire, par exemple polygonale). Une différence de pressions dans les cavités 108.1 et 108.2 peut également être obtenue en réalisant la couche 110 telle que les différentes parties 116 de cette couche destinées à être traversées par le gaz n'aient pas des largeurs similaires, ce gaz traversant alors des portions 116 de matériau perméable de sections différentes.

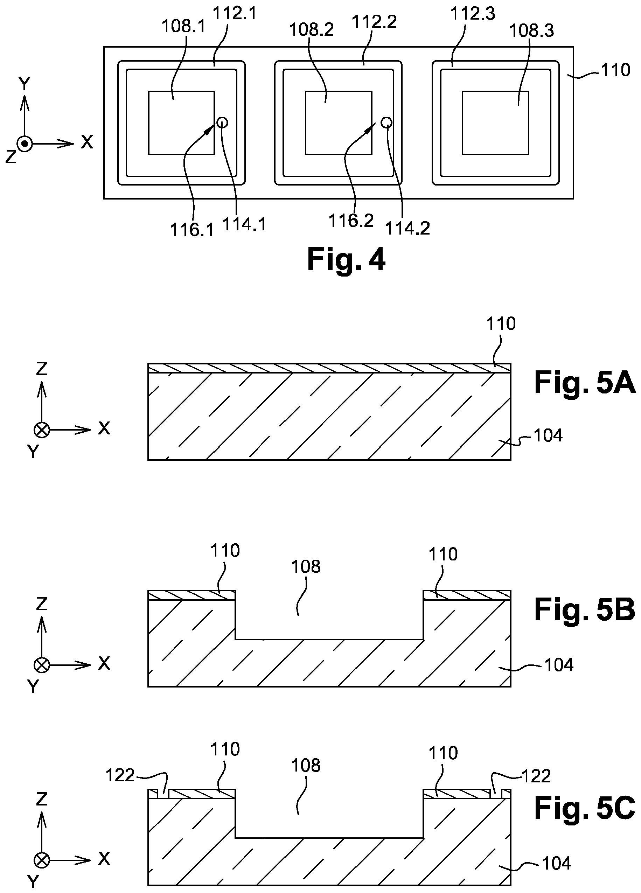

Dans le premier mode de réalisation précédemment décrit, une seule portion 112 sépare deux cavités 108 adjacentes. En variante, il est possible que plusieurs portions 112 de matériau non perméable vis-à-vis du gaz injecté dans les cavités 108 soient réalisées dans la couche 110, telles que chaque portion 112 entoure l'une des cavités 108. Sur l'exemple de la figure 4, chacune des cavités 108.1, 108.2 et 108.3 est entourée par une portion 112 respectivement référencées 112.1, 112.2 et 112.3 et formant chacune un cordon de matériau non perméable au gaz entourant chacune des cavités. Ainsi, deux cavités 108 adjacentes sont séparées l'une de l'autre par deux portions 112 de matériau non perméable distinctes. Une telle configuration du matériau non perméable en plusieurs cordons distincts est avantageux pour réaliser, après le bouchage des cavités 108, une découpe des substrats 102, 104 afin de former des puces individuelles comportant chacune l'un des micro-dispositifs 106. La configuration précédemment décrite en liaison avec la figure 1 est par contre suffisante lorsque les troisièmes micro-dispositifs 106.1 - 106.3 ne sont pas destinés à être séparés les uns des autres sous la forme de puces individuelles.

Les étapes d'un procédé de réalisation de la structure 100 sont décrites ci-dessous en liaison avec les figures 5A à 5I. Sur ces figures, une seule cavité 108 est représentée, bien que la structure 100 puisse comporter plusieurs cavités 108 dans lesquelles sont encapsulés plusieurs micro-dispositifs 106.

La couche 110 de matériau perméable est tout d'abord déposée sur la face du second substrat 104 qui est destinée à être disposée du côté du premier substrat 102 (figure 5A). La couche 110 comporte par exemple du SiO₂ et peut être réalisé par oxydation thermique (par voie sèche ou humide) du second substrat 104 lorsque celui-ci comporte du silicium, ou par PECVD.

La cavité 108 est ensuite réalisée à travers la couche 110 et dans une partie de l'épaisseur du deuxième substrat 104, par exemple par une gravure sèche ou humide (figure 5B).

La couche 110 est ensuite gravée localement, en périphérie de la cavité 108, afin de former dans la couche 110 un emplacement 122 dans lequel la portion 112 de matériau non perméable au gaz est destinée à être réalisée par la suite (figure 5C). L'emplacement 122 forme par exemple une tranchée entourant la cavité 108.

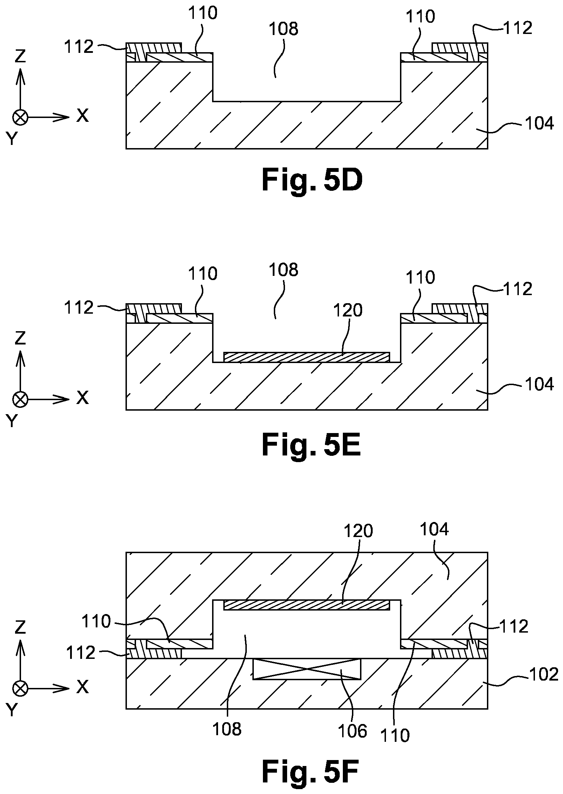

La portion 112 est ensuite réalisée en déposant dans l'emplacement 122 le ou les matériaux non perméables vis-à-vis du gaz destiné à être injecté dans la cavité 108, par exemple un dépôt d'une ou plusieurs couches métalliques dans l'emplacement 122. Sur l'exemple de la figure 5D, le ou les matériaux formant la portion 112 sont déposés dans l'emplacement 122 mais également avantageusement à côté de cet emplacement, sur une partie de la couche 110, c'est-à-dire avec une largeur (dimension selon l'axe X) supérieure à celle de l'emplacement 122. Cette portion 112 est par exemple formée par une ou plusieurs couches métalliques déposées par PVD, puis structurées par gravure. Il est toutefois possible que la portion 112 soit réalisée avec une largeur similaire à celle de l'emplacement 122, comme c'est le cas sur les figures 1 à 4 précédemment décrites, voir avec une largeur inférieure celle de l'emplacement 122. La portion 112 est donc ici disposée en partie dans la couche 110.

Comme représenté sur la figure 5E, une portion de matériau getter 120 peut être déposée sur la paroi de fond de la cavité 108, notamment lorsque la cavité 108 est destinée à comporter une pression résiduelle de gaz inférieure à environ 1 mbar une fois fermée hermétiquement.

En variante des étapes précédemment décrites en liaison avec les figures 5B à 5E, il est possible de réaliser, directement après le dépôt de la couche 110, la gravure locale de la couche 110 formant l'emplacement 122, puis la formation de la portion 112, et enfin de réaliser la gravure de la cavité 108 à travers la couche 110 et une partie de l'épaisseur du second substrat 104.

Le capot obtenu représenté sur la figure 5E est ensuite assemblé au premier substrat 102 comportant le ou les micro-dispositifs 106, par exemple par un scellement métallique (thermocompression ou eutectique), comme représenté sur la figure 5F. Du fait que la portion 112 a été précédemment réalisée telle qu'elle soit déposée dans l'emplacement 122 mais également tel qu'elle recouvre une partie de la couche 110, le matériau du capot en contact avec le premier substrat 102 correspond au matériau de la portion 112 qui sert donc de joint de scellement. L'assemblage entre le premier substrat 102 et le deuxième substrat 104 est assuré à la fois par la portion 112 et par la couche 110.

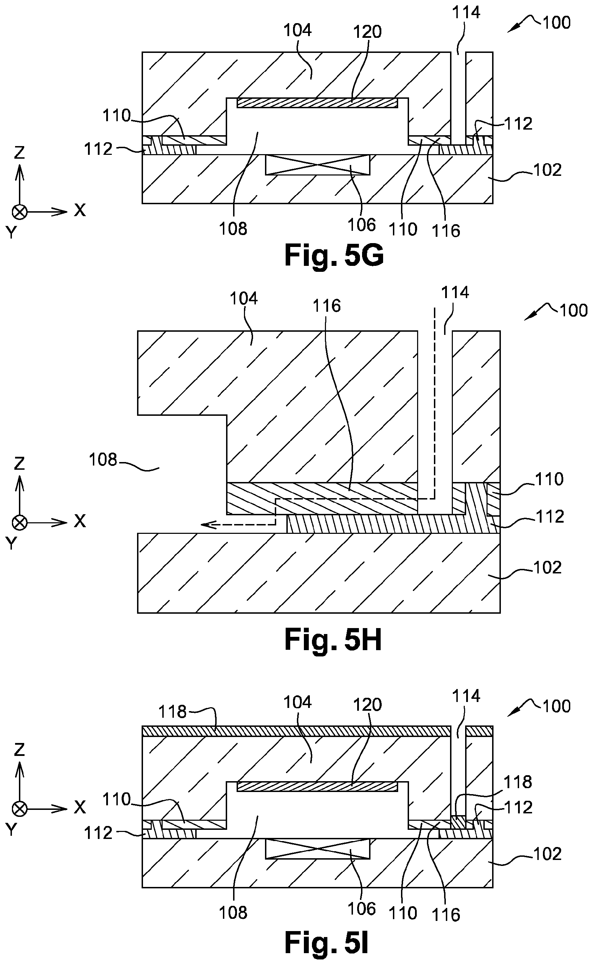

L'ouverture 114 est ensuite réalisée par gravure à travers le deuxième substrat 104 et la couche 110 telle qu'elle débouche dans la partie de la couche 110 qui est délimitée par la portion 112 (figure 5G). Comme précédemment décrit, l'ouverture 114 peut traverser toute l'épaisseur de la couche 110 (et déboucher sur le premier substrat 102 ou sur une partie du matériau de la portion 112 comme c'est le cas sur la figure 5G), ou une partie de l'épaisseur de la couche 110, ou encore ne pas traverser la couche 110 et déboucher directement sur celle-ci.

Le gaz est ensuite injecté dans la cavité 108 via l'ouverture 114 et la partie 116 de la couche 110 qui est disposée entre l'intérieur de la cavité 108 et l'ouverture 114 et qui forme un canal de matériau perméable à ce gaz. Le trajet du gaz lors de cette étape d'injection est représenté en traits pointillés sur la figure 5H. La figure 5H illustre bien le fait que le gaz injecté dans l'ouverture 114 ne peut passer que par le canal formé par la partie 116 de la couche 110 et que ce gaz est bloqué dans l'autre sens par la portion 112. Ainsi, les cavités adjacentes ne sont pas impactées par la perméation du gaz passant dans l'ouverture 114.

Comme représenté sur la figure 5I, la structure 100 est achevée en réalisant le bouchage de l'ouverture 114 par le dépôt de la couche de matériau de bouchage 118 dans l'ouverture 114, et ici également sur le deuxième substrat 104.

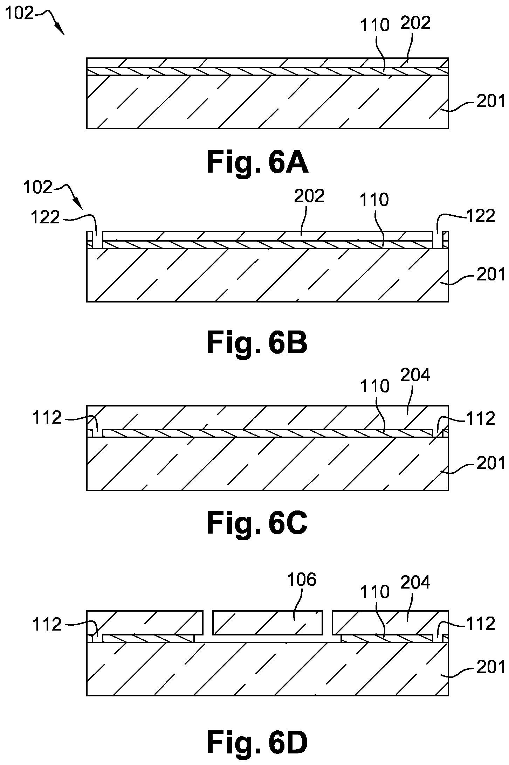

Un procédé de réalisation de la structure d'encapsulation 100 selon un deuxième mode de réalisation est décrit ci-dessous en liaison avec les figures 6A à 6K.

Ce deuxième mode de réalisation diffère du premier mode de réalisation en ce que le gaz est destiné à être injecté dans les cavités à travers des ouvertures et des canaux réalisés dans le premier substrat comportant les micro-dispositifs. Comme pour les précédentes figures 5A à 5I, une seule cavité 108 est représentée sur les figures 6A à 6K, bien que la structure 100 puisse comporter plusieurs cavités 108 dans lesquelles sont encapsulés plusieurs micro-dispositifs 106.

Dans ce deuxième mode de réalisation, la structure 100 est réalisée à partir d'un premier substrat 102 de type SOI (Silicium sur Isolant), ou plus généralement de type semi-conducteur sur isolant, comportant une couche massive 201, ou couche support, la couche 110 disposée sur la couche 201 et correspondant à la couche isolante enterrée (BOX) du substrat SOI et dont le matériau (SiO₂ par exemple) est perméable vis-à-vis du gaz destiné à être injecté dans les cavités de la structure d'encapsulation 100, et une couche superficielle, ou couche supérieure, de semi-conducteur 202, ici de silicium, disposée sur la couche 110 et dont l'épaisseur est par exemple inférieure à environ 1 µm (figure 6A).

L'emplacement 122 de la portion 112 destinée à fermer hermétiquement la cavité 108 au niveau de la couche 110 est ensuite gravé à travers les couches 202 et 110 (figure 6B).

Comme représenté sur la figure 6C, une couche épaisse de semi-conducteur de même nature que celui de la couche 202 est ensuite formée sur la couche 202 et dans l'emplacement 122 précédemment réalisé. Cette étape est par exemple réalisée par dépôt, par exemple par épitaxie, et par exemple sur une épaisseur correspondant à l'épaisseur de semi-conducteur souhaitée pour la réalisation du micro-dispositif 106, par exemple entre environ 2 µm et 100 µm. La couche 202 et le semi-conducteur déposé forment ensemble une couche 204 de semi-conducteur disposée sur la couche 110 et, dans l'emplacement 122, le semi-conducteur déposé forme la portion 112 de matériau non perméable au gaz.

La couche 204 est ensuite structurée par gravure pour obtenir le micro-dispositif 106, typiquement par gravure profonde du semi-conducteur de la couche 204 puis une libération du micro-dispositif 106 par gravure par exemple humide de parties de la couche 110 auxquelles le micro-dispositif 106 est solidarisé (figure 6D).

Un substrat de type autre qu'un substrat SOI peut être utilisé pour la réalisation du micro-dispositif 106. Il est par exemple possible d'utiliser un substrat massif (de type bulk) de semi-conducteur, formant le premier substrat 102, sur lequel sont réalisées les couches 110 et 202 par dépôts successifs. Il est également possible d'utiliser un substrat de type BSOI (Bonded SOI) qui a la particularité d'avoir une couche supérieure de semi-conducteur très épaisse (typiquement entre environ 10 µm et 100 µm). Toutefois, l'utilisation d'un substrat SOI comportant une couche superficielle fine a pour avantage, par rapport à l'utilisation d'un substrat de type BSOI, de faciliter la création des emplacements 122 et le bouchage de ces emplacements par du semi-conducteur en raison de la finesse de la couche superficielle 202.

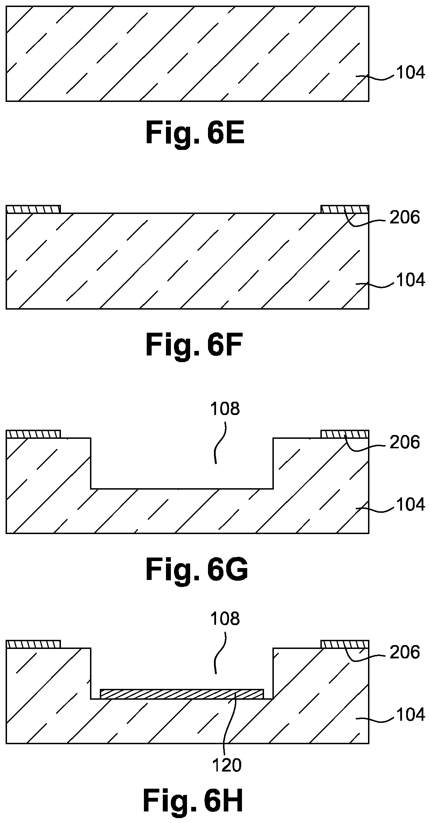

Parallèlement à la réalisation de la couche 110 et du micro-dispositif 106 sur le premier substrat 102, le capot de la structure d'encapsulation 100 est réalisé à partir du deuxième substrat 104 (figure 6E).

Un cordon de scellement 206, destiné à solidariser le deuxième substrat 104 au premier substrat 102, est ensuite réalisé sur l'une des faces du deuxième substrat 104 (figure 6F). Le cordon de scellement 206 comporte par exemple un ou plusieurs matériaux métalliques lorsque la solidarisation entre les substrats 102 et 104 est destinée à être réalisée par scellement métallique.

La cavité 108 est ensuite réalisée à travers le deuxième substrat 104 (figure 6G).

Une portion de matériau getter 120 peut être réalisée dans la cavité 108, notamment lorsque la pression recherchée dans la cavité 108 après fermeture hermétique de celle-ci est inférieure à environ 1 mbar (figure 6H).

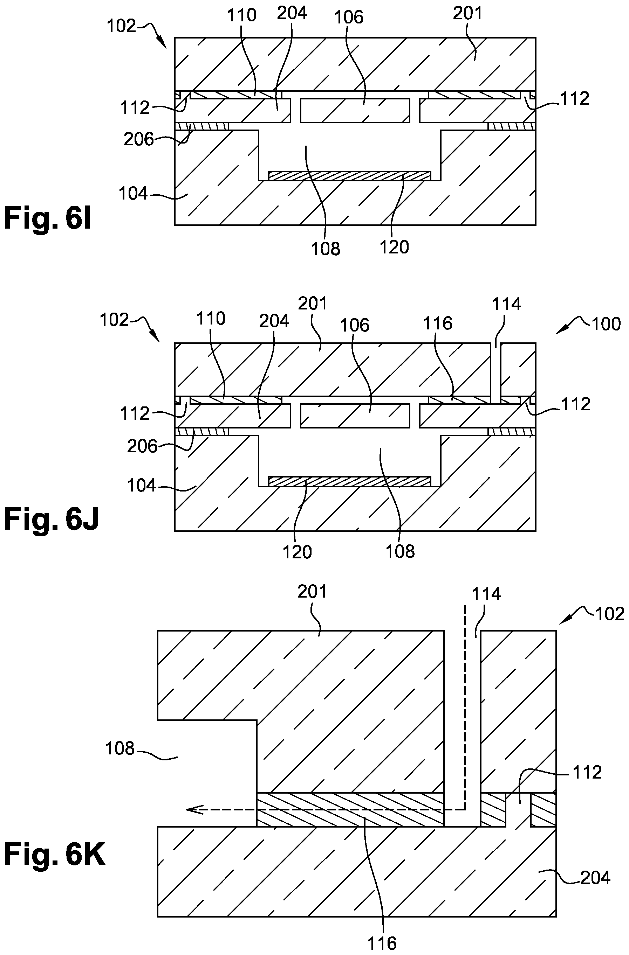

Le capot ainsi obtenu est assemblé au premier substrat 102, et plus précisément à la couche 204, par exemple par un procédé de scellement de type métallique (thermocompression ou eutectique), via le cordon de scellement 206 (figure 6I).

L'ouverture 114 est ensuite réalisée depuis la face arrière du premier substrat 102, à travers la couche 201 et la couche 110 telle que l'ouverture 114 débouche sur ou dans la partie de la couche 110 qui est entourée par la portion 112 (figure 6J).

Le gaz est ensuite injecté dans l'ouverture 114. Le trajet du gaz dans l'ouverture 114 et dans la partie 116 de la couche 110 destinée à être traversée par le gaz est représenté en pointillés sur la figure 6K. Comme précédemment, la pression résiduelle de gaz obtenue dans la cavité 108 dépend des dimensions de la section de l'ouverture 114, de la géométrie de la partie 116 (longueur et section) ainsi que de la pression et de la durée avec lesquelles le gaz est envoyé dans l'ouverture 114.

Après l'injection de gaz dans la cavité 108, la structure d'encapsulation 100 est bouchée en déposant la couche de matériau de bouchage 118, comme précédemment décrit pour le premier mode de réalisation, c'est-à-dire au moins dans l'ouverture 114 et éventuellement sur l'ensemble de la face arrière du premier substrat 102.

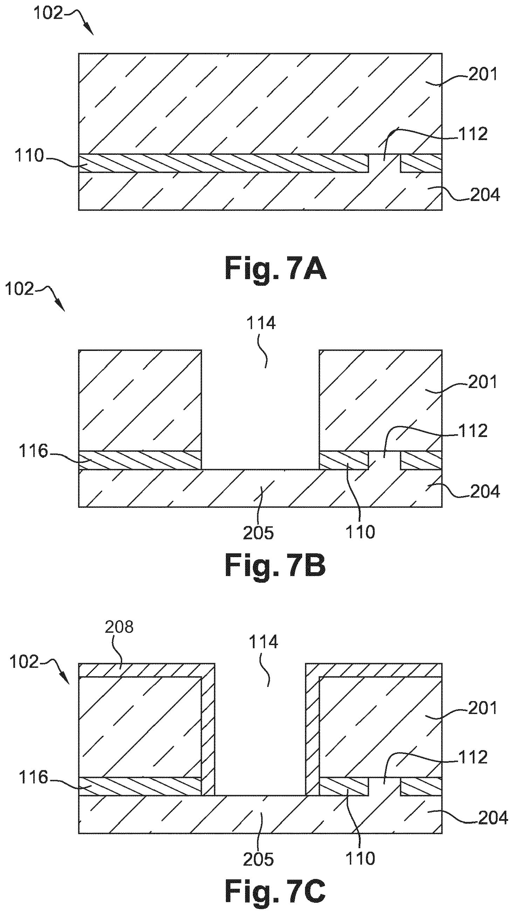

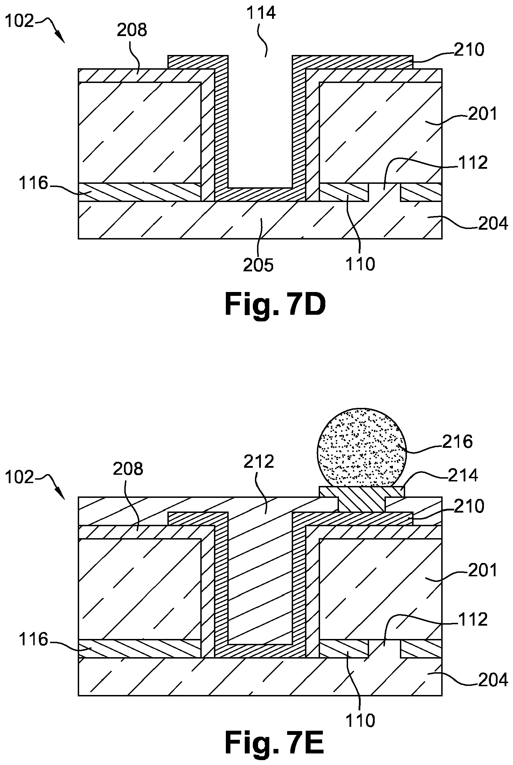

Quel que soit le mode de réalisation de la structure d'encapsulation 100, l'ouverture 114 réalisée à travers le premier substrat 102 ou à travers le deuxième substrat 104 peut servir en outre à la réalisation d'un via conducteur (ou TSV, c'est-à-dire *« Through Silicon Via* »). Les figures 7A à 7E représentent une partie des étapes d'un procédé de réalisation de la structure d'encapsulation 100 selon une variante du deuxième mode de réalisation dans laquelle l'ouverture 114 sert à la réalisation d'un via conducteur. Sur les figures 7A à 7E, la structure d'encapsulation 100 n'est que partiellement représentée.

Les étapes précédemment décrites en liaison avec les figures 6A à 6I sont tout d'abord mises en oeuvre. Sur la figure 7A, une partie de la structure 100 dans laquelle l'ouverture sera réalisée est représentée.

L'ouverture 114 est ensuite réalisée depuis la face arrière du premier substrat 102, à travers la couche 201 et la couche 110, telle qu'elle débouche sur une partie 205 de la couche 204 formant une électrode du micro-dispositif 106 (figure 7B).

Une couche de passivation 208 est ensuite formée, par exemple par un dépôt d'oxyde, de manière conforme sur la couche 201 et sur les parois latérales de l'ouverture 114 (figure 7C). La partie de la couche de passivation 208 déposée initialement sur la paroi de fond de l'ouverture 114, c'est-à-dire sur la partie 205 formant une électrode du micro-dispositif 106, est supprimée, par exemple par gravure, afin de rendre accessible cette électrode depuis l'ouverture 114.

Un gaz est ensuite injecté dans la cavité 108 par l'ouverture 114 et la partie 116 de la couche 110.

Une couche électriquement conductrice 210, par exemple métallique, est ensuite formée sur une partie de la couche de passivation 208 se trouvant sur la face extérieure de la couche 201 et sur la partie 205 de la couche 204 (figure 7D). La couche 210 forme ainsi une liaison électrique entre la partie 205 et l'une des faces extérieures de la structure 100 (ici au niveau de la face arrière du premier substrat 102). La couche 210 sert également d'écran vis-à-vis du gaz injecté dans la cavité 108 et bouche ainsi hermétiquement la cavité 108.

La structure 100 est ensuite achevée en déposant une deuxième couche de passivation 212 recouvrant la couche électriquement conductrice 210. Une ouverture est ensuite formée à travers la deuxième couche de passivation 212, en regard d'une partie de la couche 210 au niveau de laquelle une reprise de contact électrique est destinée à être réalisée. Une métallisation 214 est ensuite réalisée dans cette ouverture et une bille de connexion 216, servant de contact électrique pour la partie 205, est formée sur la métallisation 214.

## Revendications

1. Structure d'encapsulation (100) comportant au moins :
- un capot (104) solidarisé à au moins un premier substrat (102) et formant au moins une cavité (108) entre le capot (104) et le premier substrat (102) ;
- une couche (110) d'au moins un premier matériau perméable à un gaz, disposée dans le capot (104) et/ou dans le premier substrat (102) et/ou à l'interface entre le capot (104) et le premier substrat (102), et formant au moins une partie d'une paroi de la cavité (108) ;
- une portion (112) d'au moins un deuxième matériau non perméable audit gaz, dont l'épaisseur est supérieure ou égale à celle de la couche (110) du premier matériau, et entourant, dans le plan de la couche (110) du premier matériau, au moins une première partie (116) de la couche (110) du premier matériau formant ladite partie de la paroi de la cavité (108) ;
- une ouverture (114) traversant le capot (104) ou le premier substrat (102) et débouchant sur ou dans ladite partie (116) de la couche (110) du premier matériau.

2. Structure d'encapsulation (100) selon la revendication 1, dans laquelle ladite partie (116) de la couche (110) du premier matériau entoure la cavité (108).

3. Structure d'encapsulation (100) selon l'une des revendications précédentes, comportant en outre au moins un micro-dispositif (106) disposé dans la cavité (108).

4. Structure d'encapsulation (100) selon l'une des revendications précédentes, dans laquelle le deuxième matériau est un métal et/ou dans laquelle le premier matériau comporte de l'oxyde de semi-conducteur et/ou du nitrure de semi-conducteur et/ou du verre.

5. Structure d'encapsulation (100) selon l'une des revendications précédentes, dans laquelle au moins une partie de la portion (112) du deuxième matériau est entourée par une deuxième partie de la couche (110) du premier matériau.

6. Structure d'encapsulation (100) selon l'une des revendications précédentes, dans laquelle le capot (104) comporte au moins un deuxième substrat.

7. Structure d'encapsulation (100) selon la revendication 6, dans laquelle la couche (110) du premier matériau et la portion (112) du deuxième matériau sont disposées à l'interface entre le premier substrat (102) et le deuxième substrat.

8. Structure d'encapsulation (100) selon l'une des revendications 1 à 6, dans laquelle la couche (110) du premier matériau est disposée entre une couche support (201) du premier substrat (102) et une couche supérieure (204) du premier substrat (102).

9. Structure d'encapsulation (100) selon les revendications 3 et 8, dans laquelle la couche supérieure (204) du premier substrat (102) est une couche de semi-conducteur dans laquelle le micro-dispositif (106) est réalisé.

10. Structure d'encapsulation (100) selon la revendication 9, dans laquelle le deuxième matériau correspond à un semi-conducteur similaire à celui de la couche supérieure (204) du premier substrat (102), et/ou dans laquelle le premier substrat (102) est de type SOI et la couche (110) du premier matériau correspond à la couche isolante du premier substrat (102).

11. Structure d'encapsulation (100) selon l'une des revendications précédentes, comportant en outre au moins un matériau de bouchage (118, 210) disposé sur et/ou dans l'ouverture (114) tel que la cavité (108) soit fermée hermétiquement.

12. Structure d'encapsulation (100) selon la revendication 11, dans laquelle l'ouverture (114) traverse ladite partie (116) de la couche (110) du premier matériau et débouche sur une portion (205) de matériau électriquement conducteur, et le matériau de bouchage correspond à une couche électriquement conductrice (210) disposée au moins dans l'ouverture (114) et reliant électriquement la portion (205) de matériau électriquement conducteur à un contact électrique (214, 216) disposé hors de l'ouverture (114).

13. Structure d'encapsulation (100) selon l'une des revendications précédentes, comportant plusieurs cavités (108.1, 108.2) formées entre le capot (104) et le premier substrat (102) et disposées de manière adjacentes les unes par rapport aux autres, dans laquelle au moins une dimension de chacune des parties (116.1, 116.2) de la couche (110) du premier matériau formant les parties de la paroi d'au moins deux des cavités (108.1, 108.2) est différente pour chacune desdites au moins deux des cavités (108.1, 108.2) et/ou dans laquelle une dimension d'une section de l'ouverture (114.1, 114.2) associée à chacune d'au moins deux des cavités (108.1, 108.2) est différente.

14. Structure d'encapsulation (100) selon la revendication 13, dans laquelle les portions (112) du deuxième matériau entourant chacune des parties (116.1, 116.2) de la couche (110) du premier matériau formant la partie de la paroi de chacune des cavités (108.1, 108.2) sont distinctes les unes des autres.

15. Procédé de réalisation d'une structure d'encapsulation (100), comportant au moins les étapes suivantes :
- réalisation d'au moins un capot (104) et d'au moins un premier substrat (102) destinés à être solidarisés l'un à l'autre en formant au moins une cavité (108) entre le capot (104) et le premier substrat (102) ;
- réalisation d'une couche (110) d'au moins un premier matériau perméable à au moins un gaz, disposée dans le capot (104) et/ou dans le premier substrat (102) et/ou à une interface entre le capot (104) et le premier substrat (102), et destinée à former au moins une partie d'une paroi de la cavité (108) ;
- réalisation d'au moins une portion (112) d'au moins un deuxième matériau non perméable audit gaz, dont l'épaisseur est supérieure ou égale à celle de la couche (110) du premier matériau, et entourant, dans le plan de la couche (110) du premier matériau, au moins une première partie (116) de la couche (110) du premier matériau destinée à former ladite partie de la paroi de la cavité (108) ;
- solidarisation du capot (104) au premier substrat (102), formant la cavité (108) ;
- réalisation d'au moins une ouverture (114) traversant le capot (104) ou le premier substrat (102) et débouchant sur ou dans ladite partie de la couche (110) du premier matériau.

16. Procédé de réalisation selon la revendication 15, comportant en outre, après l'étape de réalisation de l'ouverture (114), une étape d'injection dudit gaz dans la cavité (108) à travers l'ouverture (114) et ladite partie (116) de la couche (110) du premier matériau, puis une étape de fermeture hermétique de la cavité (108) par la formation d'au moins un matériau de bouchage (118, 210) sur et/ou dans l'ouverture (114).

## Patentansprüche

1. Einkapselungsstruktur (100), zumindest enthaltend:
- eine Abdeckung (104), die fest mit zumindest einem ersten Substrat (102) verbunden ist und zumindest einen Hohlraum (108) zwischen der Abdeckung (104) und dem ersten Substrat (102) bildet;
- eine Schicht (110) aus zumindest einem gasdurchlässigen ersten Material, die in der Abdeckung (104) und/oder in dem ersten Substrat (102) und/oder an der Grenzfläche zwischen der Abdeckung (104) und dem ersten Substrat (102) angeordnet ist und zumindest einen Teil einer Wandung des Hohlraums (108) bildet;
- einen Abschnitt (112) aus zumindest einem gasundurchlässigen zweiten Material, dessen Materialstärke größer oder gleich der der Schicht (110) aus dem ersten Material ist und der in der Ebene der Schicht (110) aus dem ersten Material zumindest einen ersten Teil (116) der Schicht (110) aus dem ersten Material umgibt, der den Teil der Wandung des Hohlraums (108) bildet;
- eine Öffnung (114), welche sich durch die Abdeckung (104) oder das erste Substrat (102) erstreckt und auf oder in dem ersten Teil (116) der Schicht (110) aus dem ersten Material ausmündet.

2. Einkapselungsstruktur (100) nach Anspruch 1, wobei der Teil (116) der Schicht (110) aus dem ersten Material den Hohlraum (108) umgibt.

3. Einkapselungsstruktur (100) nach einem der vorangehenden Ansprüche, ferner enthaltend zumindest ein Mikrobauteil (106), das in dem Hohlraum (108) angeordnet ist..

4. Einkapselungsstruktur (100) nach einem der vorangehenden Ansprüche, wobei das zweite Material ein Metall ist und/oder wobei das erste Material halbleitendes Oxid und/oder halbleitendes Nitrid und/oder Glas enthält.

5. Einkapselungsstruktur (100) nach einem der vorangehenden Ansprüche, wobei zumindest ein Teil des Abschnitts (112) aus dem zweiten Material von einem zweiten Teil der Schicht (110) aus dem ersten Material umgeben wird.

6. Einkapselungsstruktur (100) nach einem der vorangehenden Ansprüche, wobei die Abdeckung (104) zumindest ein zweites Substrat enthält.

7. Einkapselungsstruktur (100) nach Anspruch 6, wobei die Schicht (110) aus dem ersten Material und der Abschnitt (112) aus dem zweiten Material an der Grenzfläche zwischen dem ersten Substrat (102) und dem zweiten Substrat angeordnet sind.

8. Einkapselungsstruktur (100) nach einem der Ansprüche 1 bis 6, wobei die Schicht (110) aus dem ersten Material zwischen einer Trägerschicht (201) des ersten Substrats (102) und einer oberen Schicht (204) des ersten Substrats (102) angeordnet ist.

9. Einkapselungsstruktur (100) nach den Ansprüchen 3 und 8, wobei die obere Schicht (204) des ersten Substrats (102) eine Halbleiterschicht ist, in welcher das Mikrobauteil (106) ausgebildet ist.

10. Einkapselungsstruktur (100) nach Anspruch 9, wobei das zweite Material einem Halbleiter ähnlich wie dem der oberen Schicht (204) des ersten Substrats (102) entspricht, und/oder wobei das erste Substrat (102) vom Typ SOI ist und die Schicht (110) aus dem ersten Material der Isolierschicht des ersten Substrats (102) entspricht.

11. Einkapselungsstruktur (100) nach einem der vorangehenden Ansprüche, ferner enthaltend zumindest ein Stopfmaterial (118, 210), das an und/oder in der Öffnung (114) so angeordnet ist, dass der Hohlraum (108) hermetisch verschlossen wird.

12. Einkapselungsstruktur (100) nach Anspruch 11, wobei die Öffnung (114) den Teil (116) der Schicht (110) aus dem ersten Material durchsetzt und an einem Abschnitt (205) aus elektrisch leitendem Material ausmündet, und das Stopfmaterial einer elektrisch leitenden Schicht (210) entspricht, die zumindest in der Öffnung (114) angeordnet ist und den Abschnitt (205) aus dem elektrisch leitenden Material mit einem elektrischen Kontaktstück (214, 216) elektrisch verbindet, das außerhalb der Öffnung (114) angeordnet ist.

13. Einkapselungsstruktur (100) nach einem der vorangehenden Ansprüche, enthaltend mehrere Hohlräume (108.1, 108.2), die zwischen der Abdeckung (104) und dem ersten Substrat (102) ausgebildet sind und aneinander angrenzend angeordnet sind, wobei zumindest eine Abmessung eines jeden der Teile (116.1, 116.2) der Schicht (110) aus dem ersten Material die Teile der Wandung von zumindest zwei der Hohlräume (108.1, 108.2) für jeden der zumindest zwei Hohlräume (108.1, 108.2) unterschiedlich ist und/oder wobei eine Abmessung eines Querschnitts der jedem der zumindest zwei Hohlräume (108.1, 108.2) zugeordneten Öffnung (114.1, 114.2) unterschiedlich ist.

14. Einkapselungsstruktur (100) nach Anspruch 13, wobei die jeden der Teile (116.1, 116.2) der Schicht (110) aus dem ersten Material umgebenden Abschnitte (112) aus dem zweiten Material, die den Teil der Wandung eines jeden der Hohlräume (108.1, 108.2) bilden, separat voneinander vorliegen.

15. Verfahren zum Herstellen einer Einkapselungsstruktur (100), umfassend zumindest die nachfolgenden Schritte:
- Ausbilden zumindest einer Abdeckung (104) und zumindest eines ersten Substrats (102), die dazu bestimmt sind, fest miteinander verbunden zu werden, indem sie zumindest einen Hohlraum (108) zwischen der Abdeckung (104) und dem ersten Substrat (102) bilden;
- Ausbilden einer Schicht (110) aus zumindest einem gasdurchlässigen ersten Material, die in der Abdeckung (104) und/oder in dem ersten Substrat (102) und/oder an der Grenzfläche zwischen der Abdeckung (104) und dem ersten Substrat (102) angeordnet und dazu bestimmt ist, zumindest einen Teil einer Wandung des Hohlraums (108) zu bilden;
- Ausbilden zumindest eines Abschnitts (112) aus zumindest einem gasundurchlässigen zweiten Material, dessen Materialstärke größer oder gleich der der Schicht (110) aus dem ersten Material ist und der in der Ebene der Schicht (110) aus dem ersten Material zumindest einen ersten Teil (116) der Schicht (110) aus dem ersten Material umgibt, der dazu bestimmt ist, den Teil der Wandung des Hohlraums (108) zu bilden;
- festes Verbinden der Abdeckung (104) mit dem ersten Substrat (102), wodurch der Hohlraum (108) gebildet wird;
- Ausbilden zumindest einer Öffnung (114), welche sich durch die Abdeckung (104) bzw. das erste Substrat (102) erstreckt und auf oder in dem Teil der Schicht (110) aus dem ersten Material ausmündet.

16. Herstellungsverfahren nach Anspruch 15, ferner umfassend nach dem Schritt des Ausbildens der Öffnung (114) einen Schritt des Einspritzens von Gas in den Hohlraum (108) durch die Öffnung (114) und den Teil (116) der Schicht (110) aus dem ersten Material hindurch, dann einen Schritt des hermetischen Verschließens des Hohlraums (108) durch Ausbilden zumindest eines Stopfmaterials (118, 120) an und/oder in der Öffnung (114).

## Claims

1. A packaging structure (100) including at least:
- a cap (104) secured to at least one first substrate (102) and forming at least one cavity (108) between the cap (104) and the first substrate (102);
- a layer (110) of at least one first material permeable to a gas, arranged in the cap (104) and/or in the first substrate (102) and/or at the interface between the cap (104) and the first substrate (102), and forming at least one part of a wall of the cavity (108);
- a portion (112) of at least one second material non-permeable to said gas, the thickness of which is higher than or equal to that of the layer (110) of the first material, and surrounding at least one first part (116) of the layer (110) of the first material forming said part of the wall of the cavity (108) in the plane of the layer (110) of the first material;
- an aperture (114) passing through the cap (104) or the first substrate (102) and opening onto or into said part (116) of the layer (110) of the first material.

2. The packaging structure (100) according to claim 1, wherein said part (116) of the layer (110) of the first material surrounds the cavity (108).

3. The packaging structure (100) according to one of previous claims, further including at least one micro-device (106) arranged in the cavity (108).

4. The packaging structure (100) according to one of previous claims, wherein the second material is a metal and/or wherein the first material includes semiconductor oxide and/or semiconductor nitride and/or glass.

5. The packaging structure (100) according to one of previous claims, wherein at least one part of the portion (112) of the second material is surrounded by a second part of the layer (110) of the first material.

6. The packaging structure (100) according to one of previous claims, wherein the cap (104) includes at least one second substrate.

7. The packaging structure (100) according to claim 6, wherein the layer (110) of the first material and the portion (112) of the second material are arranged at the interface between the first substrate (102) and the second substrate.

8. The packaging structure (100) according to one of previous claims 1 to 6, wherein the layer (110) of the first material is arranged between a support layer (201) of the first substrate (102) and an upper layer (204) of the first substrate (102).

9. The packaging structure (100) according to claims 3 and 8, wherein the upper layer (204) of the first substrate (102) is a semiconductor layer in which the micro-device (106) is made.

10. The packaging structure (100) according to claim 9, wherein the second material corresponds to a semiconductor similar to that of the upper layer (204) of the first substrate (102), and/or wherein the first substrate (102) is of the SOI-type and the layer (110) of the first material corresponds to the insulating layer of the first substrate (102).

11. The packaging structure (100) according to one of previous claims, further including at least one plugging material (118, 210) arranged on and/or in the aperture (114) such that the cavity (108) is hermetically closed.

12. The packaging structure (100) according to claim 11, wherein the aperture (114) passes through said part (116) of the layer (110) of the first material and opens onto a portion (205) of electrically conducting material, and the plugging material corresponds to an electrically conducting layer (210) arranged at least in the aperture (114) and electrically connecting the portion (205) of the electrically conducting material to an electrical contact (214, 216) arranged outside the aperture (114).

13. The packaging structure (100) according to one of previous claims, including several cavities (108.1, 108.2) formed between the cap (104) and the first substrate (102) and arranged adjacent to each other, wherein at least one dimension of each of the parts (116.1, 116.2) of the layer (110) of the first material forming the parts of the wall of at least two of the cavities (108.1, 108.2) is different for each of said at least two of said cavities (108.1, 108.2) and/or wherein a dimension of a cross-section of the aperture (114.1, 114.2) associated with each of at least two of the cavities (108.1, 108.2) is different.

14. The packaging structure (100) according to claim 13, wherein the portions (112) of the second material surrounding each of the parts (116.1, 116.2) of the layer (110) of the first material forming the part of the wall of each of the cavities (108.1, 108.2) are distinct from each other.

15. A method for manufacturing a packaging structure (100), including at least the following steps of:
- making at least one cap (104) and at least one first substrate (102) for being secured to each other by forming at least one cavity (108) between the cap (104) and the first substrate (102);
- making a layer (110) of at least one first material permeable to at least one gas, arranged in the cap (104) and/or in the first substrate (102) and/or at an interface between the cap (104) and the first substrate (102), and intended to form at least one part of a wall of the cavity (108);
- making at least one portion (112) of at least one second material non-permeable to said gas, the thickness of which is higher than or equal to that of the layer (110) of the first material, and surrounding at least one first part (116) of the layer (110) of the first material intended to form said part of the wall of the cavity (108) in the plane of the layer (110) of the first material;
- securing the cap (104) to the first substrate (102), forming the cavity (108);
- making at least one aperture (114) passing through the cap (104) or the first substrate (102) and opening onto or into said part of the layer (110) of the first material.

16. The manufacturing method according to claim 15, further including, after the step of making the aperture (114), a step of injecting said gas into the cavity (108) through the aperture (114) and said part (116) of the layer (110) of the first material, and then a step of hermetically closing the cavity (108) by forming at least one plugging material (118, 210) on and/or in the aperture (114).
